# EUROPEAN PATENT APPLICATION

(11) **EP 1 270 768 A1**
(43) Date of publication of application: **02.01.2003**
(21) Application number: 00957160.5
(22) Date of filing: 02.08.2000
(51) Int. Cl.: C30B 23/00, C30B 29/38

(54) **EPITAXIAL GROWING METHOD FOR GROWING ALUMINUM NITRIDE AND GROWING CHAMBER THEREFOR**

(30) Priority: 04.08.1999 RU 99117433
(71) Applicant: The Fox Group, Inc., Livermore, CA 94550 (US)
(72) Inventor: Vodakov, Jury Alexandrovich, St. Petersburg, 194017 (RU); Karpov, Sergei Jurievich, St. Petersburg, 194292 (RU); Makarov, Jury Nikolaevich, St. Petersburg, 197198 (RU); Mokhov, Evgeny Nikolaevich, St. Petersburg, 195279 (RU); Ramm, Mark Grigorievich, St. Petersburg, 192284 (RU); Roenkov, Alexandr Dmitrievich, St. Petersburg, 195220 (RU); Segal, Alexandr Solomonovich, St. Petersburg, 195299 (RU)
(74) Representative: Larsson, Karin
(86) International application number: RU0000331
(87) International publication number: WO01011116

(57) **Abstract**

The invention relates to an epitaxial growing method for growing monocrystalline aluminum nitride from a mixture of nitrogen and aluminum vapors, said method comprising the following steps: a substrate (4) and a source of aluminum (5) are placed opposite to each other inside a growing chamber (3); said substrate is heated to a temperature ensuring the growth of monocrystalline aluminum nitride, whereby said temperature is maintained. Inside the growing chamber (3), the pressure of the mixture of nitrogen and aluminum vapors is maintained, whereby said pressure exceeds, by no more than 400 millibars, a lower threshold equal to the pressure generated within a closed space by a stoichiometric mixture of nitrogen and aluminum vapors formed by evaporation of the source material (5). The invention also relates to a growing chamber (3), whereby the material in contact with the source and the aluminum vapors of the surface inside said chamber is a solid solution of tantalum carbide in carbide.

## Description

### FIELD OF THE INVENTION

The present invention relates to manufacture of monocrystalline semiconductor materials for electronic industry and particularly, to vapor-phase epitaxial growth of aluminum nitride which is very promising as a material suitable for manufacture of SAW-based devices and insulating substrates for semiconductor devices capable of operating at high temperatures.

### BACKGROUND OF THE INVENTION

Known in the art are methods of growing aluminum nitride single crystals based on vapor deposition of aluminum nitride formed on the substrate as a result of chemical reaction of an organometallic compound of aluminum with ammonia. One advantage of this group of techniques Is a relatively low temperature at which the single crystal is grown, namely, about 1000°C; the resulting growth rate, however, is too slow to allow the growing of bulk crystals on an industrial scale.

Another group of methods employed for growing single crystals of binary com-pounds, such as silicon carbide, but so far not sufficiently advanced to enable them to be applied to growing AlN single crystals, includes sublimation techniques based on recombination, on the substrate, of nitrogen and aluminum vapors obtained by evaporation of polycrystalline aluminum nitride which serves as the source material. A well-known feature of aluminum nitride is the fact that its melting point, which is only theoretically known, is substantially higher than the temperature of its decomposition into components. Therefore, the transfer of the source material to the substrate involves the formation of nitrogen and aluminum vapors which are then recombined on the substrate. One necessary condition of single crystal growing is a temperature difference between the substrate and the hotter source. A microwave source crucible induction heater with its walls made of an electroconductive material, or a conventional resistive electric heater is used to heat the source.

Major problems to be solved when growing large-size bulk single-crystals of aluminum nitride, using the sublimation technique, are a low growth rate even at temperatures of about 2000°C, and a highly corrosive effect produced by aluminum vapors, at such temperatures, on the crucible material. Materials such as tungsten, graphite and SiC-coated graphite, are known to be used for this purpose.

The closest analogy to the proposed invention is a sublimation technique described in: .C. M. Balkas et al. "Growth of bulk AlN and GaN single crystals by sublimation". Materials Research Society Symposium Proceedings vol. 449, 1997. This paper describes experiments on growing AlN single crystals In a graphite chamber with a resistive heater. The substrate was positioned in the chamber coaxially with the source surface and spaced therefrom by gaps ranging from I to 40 mm. The experiments have demonstrated unsuitability of pure graphite as the crucible material. In fact, the crucible was destroyed as a consequence of the graphite reacting with aluminum vapors which resulted In the formation of aluminum carbide (Al₄C₃). The crystals were grown using SiC-coated graphite crucibles which enabled a single process some 10 to 15 hours long, at temperatures near 2000°C, to be run. This period was long enough to cause destruction of the SiC coating as a result of aluminum diffusion through the coating and its reaction with graphite. To provide a constant evaporation rate, a polycrystalline aluminum nitride powder compact served as the source material, and silicon carbide was used as the seed crystal of the substrate. The growth process was run at temperatures ranging from 1950 to 2250°C and with nitrogen blow-through of the chamber, at a fixed pressure of 500 torr (approx. 670 mbar).

Such pressure of externally supplied nitrogen produces a great excess of nitrogen in the vapor phase as compared with the composition resulting from evaporation of the source aluminum nitride. The pressure of aluminum nitride vapors produced during the experiment at a temperature of 2250°C is shown by calculations to be as low as 200 mbar.

It is stated in the above publication that aluminum nitride features "an extremely high equilibrium nitrogen vapor pressure at moderate temperatures".

When speaking about a "high" equilibrium vapor pressure relating to one of the elements of a binary compound evaporated and decomposed into elements, it is apparent to those skilled in the art that what is meant is the comparison between equilibrium partial pressures of vapors of the elements of this compound in a closed system, being in thermal equilibrium. The statement quoted above, relating to aluminum nitride, means that the concentration of nitrogen atoms in aluminum nitride vapors by far exceeds the concentration of aluminum atoms. This is only possible if, in a closed system, the equilibrium vapor pressure is established such that the aluminum atoms change from the vapor phase to the liquid phase, avoiding recombination with nitrogen. A high background nitrogen pressure produced in these experiments is obviously dictated by the desire to avoid the risk of forming the liquid phase (drops) of aluminum, as the single crystal is grown, both on the growth surface and on the chamber walls, thus preventing the loss of aluminum and possible defects in the crystalline structure.

With a considerable excess of nitrogen in the N - Al vapor mixture, however, a slow diffusion mechanism of transferring the source material to the substrate is working, and it is the transfer rate that limits the single crystal growth rate.

In the above experiment, the growth process at a temperature of 2250°C was impeded by a rapid evaporation of SiC of the crucible coating. The 15-hour growing cycle at a rate of 30 to 50 mkm per hour was run within a temperature range of I950 to 2050°C. The estimated growth rate of 0.5 mm per hour, during a short growing period, was obtained at a source temperature of 2150°C, a substrate-to-source spacing of 4 mm, and with the substrate temperature maintained at a level at least 70°C below the source temperature.

The need to maintain a substantial temperature difference between the substrate and the source is a certain technical problem in the case of their small spacing, which can be solved by a sophisticated design and at the expense of an unreasonably high power consumption, since special measures have to be taken to provide a forced cooling of the substrate heated by a thermal radiation from the source. Besides, it will be noted that while an increased operating source temperature and its associated substrate temperature provides an increase of aluminum nitride single crystal growth rate, it results, apart from a greater power consumption, in a sharply reduced life of those parts of the equipment which operate under such elevated temperatures.

### DISCLOSURE OF THE INVENTION

It is the object of the present invention to provide a method and device for growing monocrystalline aluminum nitride, that would enable a high single crystal growth rate to be achieved under mild requirements for such process parameters as the operating temperature of the source, the spacing and the temperature gradient between the substrate and the source, while allowing, at the same time, a repeated growth of bulk single crystals without the necessity to replace parts of the equipment in use, which would ultimately ensure industrial application of the method.

This object is attained by providing that in a method of epitaxial growth of aluminum nitride single crystals out of mixture of nitrogen and aluminum vapor, including the placement in the growth chamber, opposite each other, of a substrate and an aluminum source, heating and maintaining the source and substrate temperatures, providing the formation of aluminum vapors in the mixture and the growth of the aluminum nitride single crystal on the substrate, respectively, according to the invention, the pressure of the mixture of nitrogen and aluminum vapor in the growth chamber is maintained within 400 mbar from the lower limit equal to the pressure developed in a closed preliminary evacuated volume by the mixture of nitrogen and aluminum vapors formed by evaporating of aluminum nitride heated up to the temperature of the source.

According to the present invention, the aluminum nitride single crystal growth is carried out at a minor excessive pressure, within 400 mbar, i. e. with a minor excess of nitrogen atoms, as compared to aluminum atoms, in the composition. The formation of aluminum vapors in the mixture is provided by heating of an aluminum source.

With a considerable excess of nitrogen in the mixture, the single crystal growth rate is limited by the rate of the diffusion transfer of aluminum atoms from the source to the substrate. The reduction of the nitrogen excess in the mixture down to the values at which its quantitative composition approximates the stoichiometric ratio of concentrations of nitrogen and aluminum atoms, corresponding, for the case of aluminum nitride, to their equal concentrations, results in an aluminum nitride single crystal growth rate which is increased many times over.

The growth rates increase results from the qualitative change in the aluminum atom transfer mechanism. As the stoichiometric ratio of nitrogen and aluminum atom concentrations is approached, the convective transfer process consisting in a directional movement of the constituent atoms of the source vapors towards the cooler substrate begins to dominate over the diffusion transfer mechanism, in the case of the N - Al vapor mixture, the convective transfer phenomenon has been found by the authors to be very pronounced and accompanied by an appreciably higher rate of the source material transfer to the substrate. This results in a higher single crystal growth rate which is primarily limited by the transfer rate.

At operating growth temperatures, nitrogen is present in its vapor phase as N₂ molecules, and the partial pressure ratio of nitrogen and aluminum vapors in their stoichiometric mixture is 1 to 2. Consequently, the lower limit of the specified pressure interval is 1.5 times the partial pressure of aluminum vapors resulting from evaporation of the source material within a closed space.

The pressure of the N - Al vapor mixture in the chamber is preferably maintained near the lower limit of the specified interval, corresponding to the stoichiometric ratio of nitrogen and aluminum atoms in the mixture, at which the aluminum nitride single crystal growth rate is at a maximum.

One of the embodiments of the invention is such that aluminum nitride is used as the Al source material, the growth chamber is evacuated and sealed prior to heating, and the aluminum nitride single crystal is grown at the lower value of the specified pressure interval of the N - Al vapor mixture produced in the chamber by evaporation of the source material.

It has been found by the authors that evaporation and subsequent recombination of source aluminum nitride vapors avoids the formation of the liquid phase of aluminum. As the source aluminum nitride is evaporated in the hermetically sealed chamber, a stoichiometric N - Al vapor mixture Is produced, i. e. the single crystal growth process runs at a mixture pressure equal to the lower value of the specified pressure interval which involves the convective transfer mechanism providing the maximum growth rate.

In another embodiment, the object of the invention is attained by using aluminum nitride as the Al source material and placing the growth chamber communicating with the outside in the nitrogen atmosphere, the pressure of nitrogen being maintained within a specified pressure interval inside the growth chamber.

In case aluminum nitride is used as the source material in an unsealed growth chamber, maintaining a specified quantitative composition of the mixture inside the growth chamber, by providing a specified background pressure of nitrogen on the outside, enables the single crystal growth rate to approximate that achieved through the use of a sealed growth chamber. In this case, a cheaper and more practicable embodiment is used, in terms of repeated growing cycles, which can do without sealing the growth chamber.

A further embodiment consists in that metallic aluminum is used as the Al source material, the growth chamber communicating with the environment is placed in the nitrogen atmosphere with the pressure of nitrogen maintained within a specified pressure interval inside the growth chamber. In this case, nitrogen is introduced into the mixture from the outside of the growth chamber.

The source containing metallic aluminum provides, within the temperature range below 2400°C, a higher single crystal growth rate than the source with aluminum nitride as the source material. It is preferable to maintain the temperature of the aluminum source within the interval 2000 - 2500 °C. High growth rate is provided by the method at temperatures higher 2000°C, on the other hand it is ruther difficult to conduct growth process at temperature above 2500 °C.

The aim of the invention is also attained by providing that in a growth chamber for the epitaxial growth of aluminum nitride single crystals from the N - Al vapor mixture, adapted to enclose an aluminum source and a substrate, to heat and maintain the source and substrate temperatures necessary to provide the growth of an aluminum nitride single crystal on the substrate, according to the invention, the material of the growth chamber surface contacting the source and aluminum vapors is a solid solution of tantalum carbide in tantalum.

It has been found by the authors that carbon-alloyed tantalum (Ta) is a material reactively resistant to the aluminum melt and its vapors at temperatures of at least up to 2500°C. Such material employed for the inner surface of the growth chamber permits a repeated use of the chamber, even if metallic aluminum serves as the source.

### BRIEF DESCRIPTION OF THE DRAWINGS

Fig. 1 schematically shows an aluminum nitride single crystal growing device;
Fig. 2 represents the pressure of a stoichiometric N - Al vapor mixture within a closed volume as a function of temperature, for two different aluminum source materials;
Fig. 3 is a family of curves showing the relationship between the aluminum nitride single crystal growth rate and the pressure of the N - Al vapor mixture for three different temperatures, when aluminum nitride is used as the Al source material.

### PREFERRED EMBODIMENTS OF THE INVENTION

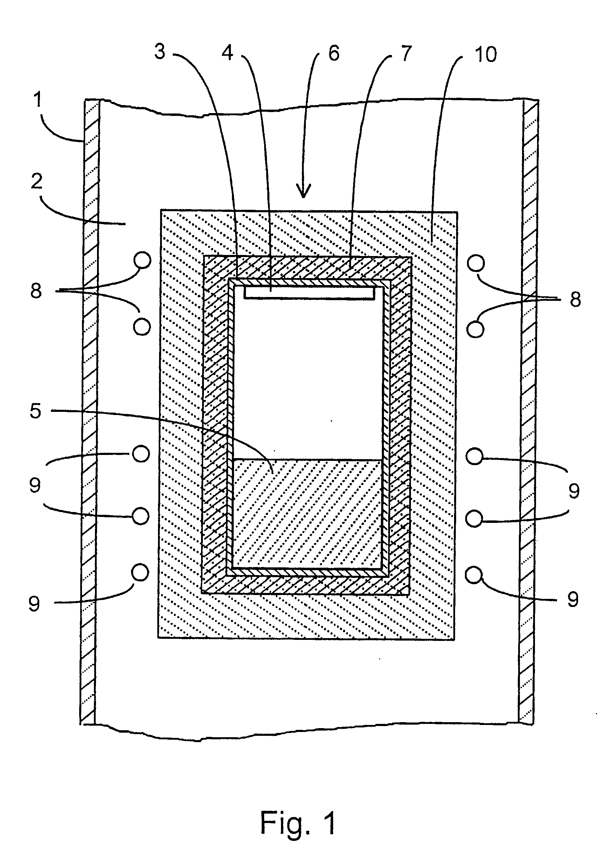

The aluminum nitride single crystal is grown, using a device represented in Fig. 1. The device comprises a case 1 composed of a material such as quartz with a cavity 2 having mounted therein a growth chamber 3 shaped as a cylinder closed by two end walls. A substrate 4 is disposed on one of the end walls of the growth chamber 3, which may take the tom of a removable cover. Monocrystalline aluminum nitride or silicon carbide having the crystalline structure similar to that of aluminum nitride serves as the material of the substrate 4. An Al source 5 is placed within the growth chamber 3 opposite the substrate 4. An Induction heater 6 comprises a cylinder-shaped induction current receiver 7 composed of electroconductive graphite, and separately energized sections 8 and 9 of microwave coils.

The receiver 7 is surrounded by a thermal insulator 10 using, for example, porous graphite as its material. Such design of the growth chamber enables the Al source 5 to be heated up to a temperature of at least 2500°C by the section 9 of the heater. The heating of the substrate 4 by the separate section 8 allows a specified positive temperature gradient to be provided between the source 5 and the substrate 4.

The mechanical design of the growth chamber is dependent on the size of the single crystals which are supposed to be grown. In order to grow thicker single crystals i. e. up to several tens of mm thick, the induction heater may be made displaceable along the growth chamber, so as to shift the resulting temperature field, as the growing surface of the single crystal changes position, thereby maintaining constant growing conditions. The induction heater may not include the separate sections 8 and 9, if the design of the growth chamber provides the desired temperature gradient between the source 5 and the substrate 4. A resistive heater may be used instead of the induction heater, its working element covering the aluminum source region.

To increase the single crystal growth rate, the temperature gradient between the source 5 and the substrate 4 is preferably maintained at several tens of degrees, the spacing of the source 5 and the substrate 4 being set as low as possible. These are two conflicting requirements, since with a small distance between the source and the substrate, it is difficult to provide a substantial temperature gradient because of the radiation heating of the substrate 4 from the source 5. This conflict may be resolved, if special measures are taken to cool down the substrate, which will lead, however, to an unproductive loss of energy. As an alternative to taking such measures, it is possible, by way of compromise, to choose the source-to-substrate spacing preferably within the range 3 ... 10 mm and the temperature gradient within the range 10 ... 30°C, respectively.

The walls of the growth chamber 3 are made of tantalum, and the inner surface of the walls is alloyed with carbon. The carbon alloying is conducted as follows. The growth chamber 3 is filled with graphite powder and slowly heated up to 2200 ... 2500°C. The temperature is raised at a constant rate for 1 to 3 hours, and then the growth chamber 3 is allowed to stay at the maximum temperature for another period of 1 to 3 hours. As a result of such treatment, the material of the inner surface of the growth chamber walls is a solid solution of tantalum carbide in tantalum which is variable in depth from the surface. The resulting refractory material was found by the authors not to react with aluminum at temperatures of at least up to 2500°C, thereby allowing repeated aluminum nitride single crystal growing cycles in such growth chamber without the necessity to replace or repair its parts. It is important that the inner walls of the growth chamber 3 treated in a manner described above essentially do not adsorb aluminum and permit the use of metallic aluminum as the Al source material.

In an embodiment of aluminum nitride vapor-grown single crystals, in a sealed growth chamber, the process runs as follows. Prior to heating, in order to remove atmospheric gases out of the cavity 2, it is blown through with pure nitrogen, with the growth chamber 3 open. Nitrogen is then pumped out of the cavity 1 and the growth chamber 3 is sealed by means of, say, vacuum welding. The growth chamber 3 may also be evacuated and sealed before placing it inside the cavity 2. The evacuation of the growth chamber 3 is carried out until a residual nitrogen pressure value is reached which is low compared to a specified range of deviations from the pressure of the stoichiometric mixture. Practically, a residual nitrogen pressure of several millibars is quite sufficient.

Following this, the source 5 in the form of a briquette pressed out of polycrystalline aluminum nitride powder and the substrate 4 are heated by the heater 6 up to operating temperatures at which the crystals are further grown. The operating temperatures most suitable for growing aluminum nitride lie within .the range of 2000 to 2500°C.

As the source 5 is heated, the initial pressure in the growth chamber 3 exerted by the nitrogen left over after evacuation, increases with evaporation of the material of the source 5. The source aluminum nitride is evaporated under stoichiometric law, i. e. as the aluminum nitride molecule is thermally decomposed, both the elements are changed to vapor phase. No liquid phase of aluminum is formed. Apart from a small initial content of nitrogen, the nitrogen and aluminum atom concentrations in the growth chamber 3 are identical. i. e. equal numbers of N and Al atoms per unit volume are present.

Thus the aluminum nitride single crystal growing in a sealed growth chamber is performed at the lower value of the N-Al vapor mixture pressure range defined by the Claims of the invention, which corresponds to the stoichiometric ratio of N and Al atom concentrations in the mixture.

With the stoichiometric composition of the N - Al vapor mixture, there occurs a convective material transfer from the source 5 to the substrate 4, which represents a directional movement of the aluminum atoms and nitrogen molecules from the source 5 to the substrate 4 and therefore, it is much more high-speed than the diffusion transfer.

In the case of diffusion transfer, the single crystal growth rate is limited by the speed of the material transfer from source 5 to substrate 4, being in inverse proportion to their spacing which is required to be low to increase the growth rate. With a purely convective transfer occurring under conditions of a precisely stoichiometric ratio of N and Al atomic concentrations, the growth rate is the higher, the higher is the pressure of the stoichiometric mixture which is determined by the evaporation speed of the source material. The evaporation speed is essentially independent of the spacing of source 5 and substrate 4. Consequently, any variation of the source-to-substrate spacing, at least within the range not going beyond the lateral dimensions of the substrate 4, does not affect the growth rate. This, in turn, permits operation with greater temperature differences between the source 5 and the substrate 4 whose increase results in a higher evaporation speed of the source material 5 and consequently, in a further increase of the single crystal growth rate.

In the hermetically sealed growth chamber 3, the source's own aluminum nitride vapors form a mixture with the stoichiometric ratio of N and Al atomic concentrations. In this case, the maximum single crystal growth rate is provided, as compared with that achieved under the same conditions, except the presence of excessive nitrogen in the mixture.

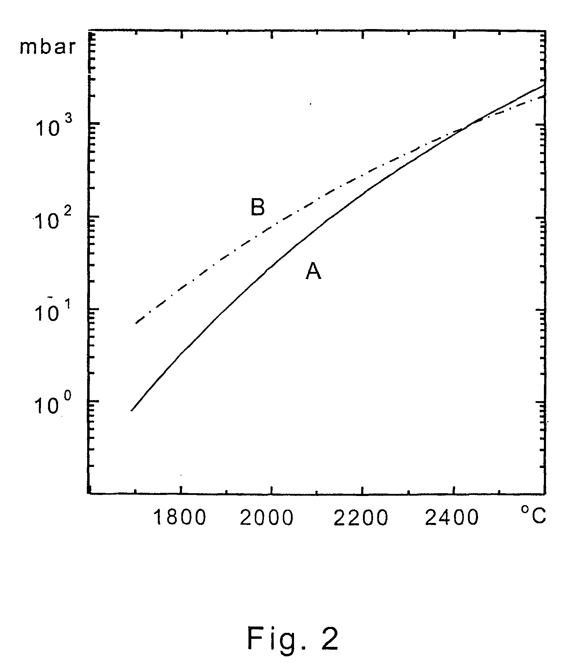

The pressure of aluminum nitride vapors in the sealed growth chamber 3 as a function of the source temperature, obtained by numerical techniques, is represented in Fig. 2 as Curve A. For example, in accordance with Curve A, an estimated vapor pressure of approx. 100 mbar corresponds to the temperature 2200°C.

The method better suited for running consecutive cycles of growing aluminum nitride single crystals is an embodiment with an unsealed growth chamber 3, allowing a ready extraction of the single crystal grown.

With polycrystalline aluminum nitride used as the Al source 5, the single crystal is grown as described hereinbelow.

Prior to heating, the source 5, the substrate 4 and the growth chamber 3 are prepared in the same manner as in the preceding embodiment.

When the single crystal is grown with the growth chamber 3 unsealed, the source vapor leakage therefrom is to be prevented. To achieve this purpose, in the cavity 2 communicating with the growth chamber 3 through gaps in its joints or through the specially provided ducts (not shown), a balancing nitrogen pressure is produced which is not below that exerted by aluminum nitride vapors of the source 5 within a closed volume. The nitrogen pressure is monitored by taking its measurements in the colder section of the cavity 2 away from the growth chamber 3. A wide assortment of instruments based on different principles are used to measure pressures involved in the present method and ranging from 1 to 2000 mbar, such as: thermocouple-based, membrane-based etc. instruments, for example, the membrane-based compound pressure and vacuum gauge MEMBRANOVAC DM-12 released for sale by LEYBOLD INFICON Inc.

The choice of nitrogen pressure in the cavity 2 is the key factor in the achievement of a high aluminum nitride single crystal growth rate with moderate values of the operating temperature of the source 5 and the temperature gradient between the source 5 and the substrate 4. To provide the maximum growth rate, the nitrogen pressure in the cavity 2 under steady-state operating temperature conditions must be equal to the pressure produced by aluminum nitride vapors in a closed volume, such as the sealed growth chamber 3, having a stoichiometric ratio of nitrogen and aluminum atomic concentrations.

The pressure in the cavity 2 corresponding to the maximum single crystal growth rate, at a specified operating temperature of the source 5 can be read from Curve A of Fig. 2, showing the pressure in millibars as a function of temperature in degrees centigrade. Curve A indicates the estimated value of pressure produced within a closed volume by the stoichiometric mixture of aluminum vapors resulting from evaporation of the source material and nitrogen, provided it is aluminum nitride that is chosen as the material of the source 5.

Prior to heating, a minimum initial pressure of nitrogen (e. g. of the order of several millibars) is established within the cavity 2 and consequently, in the growth chamber 3 being in communication therewith. As the source 5 is heated, the nitrogen pressure within the cavity 2 is raised in accordance with the estimated rise in the pressure of the source vapors, the current pressure increments being calculated from Curve A of Fig. 2. So at each particular moment in the course of heating, the pressure within the cavity 2 exceeds the estimated aluminum nitride vapor pressure in the growth chamber 3 by the value of initial pressure adjusted in the cavity 2. The above procedure of reaching the normal operating growth conditions is optimum in that it avoids, at this stage, the loss of aluminum vapors and prevents their possible contact with unprotected members of the device, if the aluminum vapors happen to go beyond the internal cavity of the growth chamber 3. This would be the case, for example, if a nitrogen pressure corresponding to the normal operating conditions were produced in the cavity 2 before the heating was started, in this case, prior to heating, nitrogen is supplied to the growth chamber 3 from the cavity 2. During the heating process, as a result of forming aluminum nitride vapors, the pressure within the growth chamber 3 comes to exceed the external pressure, and part of the N - Al vapor mixture is displaced out of the chamber into the cavity 2. In this case, an excess of nitrogen being maintained inside the growth chamber 3 would slow down the single crystal growth.

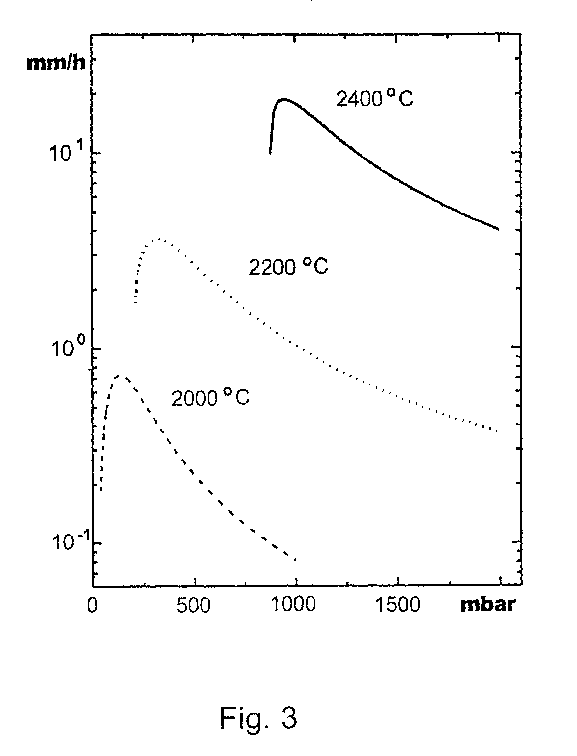

Fig. 3 represents a family of curves corresponding to three different temperatures, showing the single crystal growth rate (in mm per hour) as a function of a nitrogen pressure (in mbar) within the cavity 2, equal to the overall pressure of the N - Al vapor mixture In the growth chamber 3.The plots correspond to a temperature gradient between the source 5 made of aluminum nitride and the substrate 4 of 70°C and to a source-to-substrate spacing of 4 mm. These plots enable us to find the range of deviations from the stoichiometric ratio of nitrogen and aluminum atomic concentrations that would not result in a substantial reduction of the single crystal growth rate, and in particular, to select the value of initial nitrogen pressure in the cavity 2.

During the first growing cycle, in a specific growth chamber 3, the rate of increase of the nitrogen pressure in the cavity 2, as the source 5 is heated, may be higher than that estimated from Curve A. Fig. 2 which would lead to reaching normal growing conditions with a greater excess of nitrogen in the mixture with the consequent reduction of the growth rate. The rate of increasing the pressure and hence, the final value of nitrogen pressure in the cavity 2, may be subsequently, in accordance with the trial growth results, subjected to corrective measures to correct errors in calculations and temperature measurements.

Then using metallic aluminum as the source material, the aluminum nitride single crystal is grown in the growth chamber 3 communicating with the cavity 2 similarly to the preceding embodiment. A distinctive feature of this embodiment is the nitrogen-free source material.) The formation of the N - Al vapor mixture in the growth chamber 3 is made possible by the nitrogen supply from the cavity 2.

The change of nitrogen pressure in the cavity 2, as the source 5 is heated, follows the relationship Illustrated by Curve B, Fig.2. Curve B shows an estimated pressure exerted, within a closed volume, by a stoichiometric mixture of aluminum vapors resulting from evaporation of the source material and nitrogen, in the case where metallic aluminum is chosen as the material of the source 5.

Curve B corresponding to metallic aluminum, with moderate temperatures of the source 5, demonstrates a higher overall pressure of the stoichiometric mixture of nitrogen and aluminum vapors in the growth chamber 3 than Curve A corresponding to aluminum nitride. Since the aluminum nitride single crystal growth rate rises with increasing pressure of the stoichiometric N - Al vapor mixture, the use of metallic aluminum as the material of the source 5 provides a higher growth rate in the lower portion of the operating temperature range of the source 5, below 2400°C, which is the preferred range for practical purposes. The use of metallic aluminum as the source material permits the single crystal growth rate to be evaluated, in the course of growing, by the consumption of nitrogen necessary to maintain the constant pressure within the cavity 2. This allows the selection of appropriate process parameters directly as the crystal is being grown.

The proposed invention is not in any way restricted to the above embodiments, but permits modifications of the method apparent to those skilled in the art, embodied within the scope of the invention and defined by the Claims.

## Claims

1. A method of epitaxial growth of aluminum nitride single crystals but of a mixture of nitrogen and aluminum vapors comprising the placement in a growth chamber (3), opposite each other, of a substrate (4) and an aluminum source (5), heating and maintaining operating temperatures of the source (5) and the substrate (4), providing, the formation of aluminum vapors in the mixture and the growth of an aluminum nitride single crystal on the substrate (4), respectively, **characterized in that** the pressure of the mixture of nitrogen and aluminum vapors in the growth chamber (3) is maintained within an interval of 400 mbar from the lower limit equal to the pressure developed in a closed preliminary evacuated volume by the mixture of nitrogen and aluminum vapors formed by evaporating of aluminum nitride heated up to the temperature of the source.

2. A method of Claim 1 **characterized in that** the pressure of the mixture of nitrogen and aluminum vapors in the growth chamber (3) is maintained close to the lower limit of the specified interval.

3. A method of Claim 1 **characterized in that** aluminum nitride is used as the material of the source (5) of aluminum, the growth chamber (3) is evacuated and sealed before heating, and the aluminum nitride single crystal is grown at the lower limit of a specified interval of pressures of the mixture of nitrogen and aluminum vapors produced in the growth chamber (3) as a result of evaporation of the source material.

4. A method of Claim 1 **characterized in that** aluminum nitride is used as the material of the source (5) of aluminum, and the growth chamber (3) communicating with the environment is placed in the atmosphere of nitrogen whose pressure is maintained within a specified pressure interval.

5. A method of Claim 1 **characterized in that** metallic aluminum serves as the material of the source (5) of aluminum, and the growth chamber (3) communicating with the environment is placed in the atmosphere of nitrogen whose pressure is maintained within a specified pressure interval.

6. A method of Claim 1 **characterized in that** the temperature of the aluminum source is maintained within the interval 2000 - 2500 °C.

7. A growth chamber (3) for epitaxial growth of monocrystalline aluminum nitride out of a mixture of nitrogen and aluminum vapors, adapted to enclose the source (5) of aluminum and the substrate (4) to heat and maintain temperatures of the source (5) and the substrate (4), providing the growth of aluminum nitride single crystals on the substrate (4), **characterized in that** the material of the surface of the growth chamber, being in contact with the source and the aluminum vapors is a solid solution of tantalum carbide in tantalum.
